# EUROPEAN PATENT APPLICATION

(11) **EP 1 160 978 A1**
(43) Date of publication of application: **05.12.2001**
(21) Application number: 00111506.2
(22) Date of filing: 29.05.2000
(51) Int. Cl.: H03H 17/06, H03H 17/02

(54) **Digital filter**

(71) Applicant: Sony International (Europe) GmbH, 10785 Berlin (DE)
(72) Inventor: Wildhagen, Jens, c/o Advanced Technology Center, 70327 Stuttgart (DE); Nöthlings, Rolf, c/o Advanced Technology Center, 70327 Stuttgart (DE)
(74) Representative: Müller . Hoffmann & Partner Patentanwälte

(57) **Abstract**

To provide arbritrary cutoff frequencies or transition bands while keeping the needed processing power as low as possible a Digital filter for filtering an input signal comprises at least one filter path comprising a first mixer (1) receiving the input signal to shift a center frequency (Ω) of a frequency range to be filtered of the input signal into the low frequency range, a filter (2) with a predetermined transfer function in the low frequency range receiving the frequency shifted input signal, and a second mixer (3) to compensate the frequency shift of the first mixer and supplying an output signal of a respective filter path.

## Description

### Description

The present invention relates to a digital filter and a method for digitally filtering an input signal, in particular to an efficient realization of a very sharp filter which can easily be extended to several filter functions wherein interaction between such filter functions is avoided.

N. J. Fliege describes in his book "Multirate digital signal processing" ISBN 0-471-93976-5 in Chapter 5.3 multirate complementary filters which generally fulfill the above demands. In particular, it is shown how to realize highpass filters with cutoff frequencies in the range 0 < Ω < π/2 and lowpass filters with cutoff frequencies in the range π/2 < Ω < π.

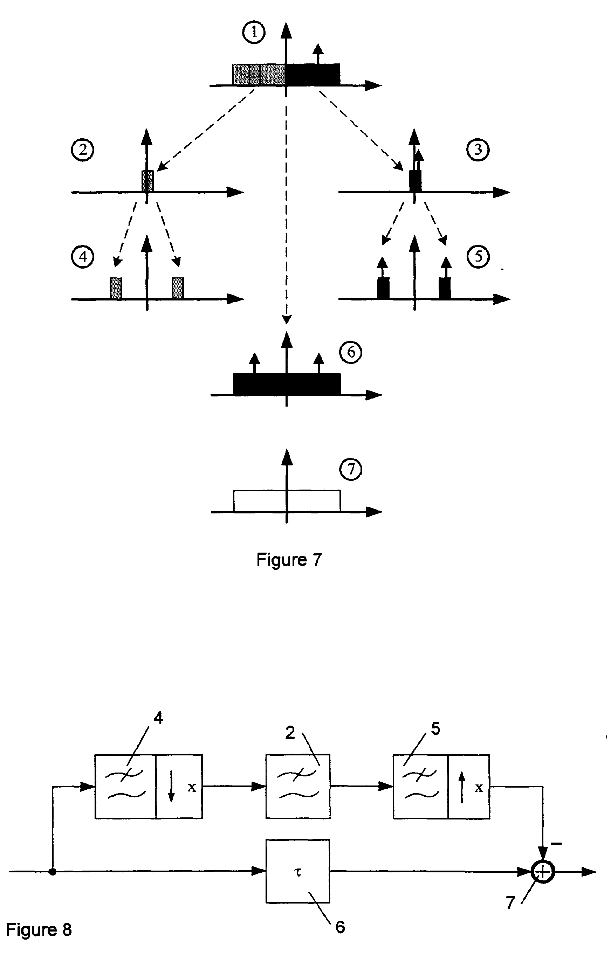

Such a filter is shown in Fig. 8. An input signal gets downsampled by a decimator 4 before it is filtered by a filter 2 and gets upsampled by an interpolator 5. Further, the input signal gets delayed by τ which corresponds to the group delay introduced during the filtering. Finally, the filtered input signal gets subtracted from the delayed input signal by an adder 7 which produces the output signal of the complementary filter.

However, such filters generally have the disadvantage that only lowpass or highpass filters can be realized. Bandpass filters can not be realized with the structure shown in Fig. 8. Further, the structure shown in Fig. 8 realizes only one stopband and one passband.

Therefore, it is the object underlying the present invention to provide a digital filter for filtering an input signal and a method for digitally filtering an input signal providing a complex lowpass, a complex highpass and/or at least one complex bandpass filter with variable cutoff frequencies while preferably providing reduced needed calculation power and memory.

A digital filter according to the present invention is defined in independent claim 1. Preferred embodiments are defined in dependent claims 2 to 7. A method for digitally filtering an input signal according to the present invention is defined in independent claim 8. Preferred embodiments thereof are respectively defined in dependent claims 9 and 10.

According to the present invention a filter with a predetermined transfer function in the low frequency range is combined with frequency shifts of the input signal to obtain an enlarged range in which filtering functions can be applied, i. e. the input signal undergoes an arbitrary frequency shift before being filtered in the low frequency range whereafter said frequency shift gets compensated. Therewith, cutoff frequencies or transition bands of a filter can be realized at arbitrary frequencies, since the actual filtering is performed in the low frequency range only.

Preferably, to reduce the needed calculation power the filtering is performed with decimated sampling rate, i.e. the frequency shifted input signal gets downsampled before being filtered and upsampled before the frequency shift gets compensated.

Further preferably, the digital filter according to the present invention incorporates a complementing multirate filter so as to achieve steep slopes in the transition band while assuring an easy adaptation to different filtering functions.

In particular, if a complex double sideband modulated signal, like a common AM radio signal, is to be processed it is easily possible to provide two filter paths, wherein one removes a respective predetermined frequency range of one sideband, e. g. a distorted frequency range, and the other inserts a corresponding frequency part of the other sideband - which comprises the same information due to the signal characteristics - so as to provide an undistorted signal without information loss.

Preferably, to further save calculation power in this case only the real part of the input signal gets delayed and only the real part is taken of the output signal of each filter path, i. e. of the second mixer which compensates the frequency shift of the first mixer after the filtering is performed, to calculate the output signal of the digital filter according to the present invention.

Therefore, the present invention allows to realise a filter with sharp band stops and a sharp frequency selective gain by a factor of 2 at any frequency without changing filter coefficients with minimum memory and calculation power requirements.

The present invention and its embodiments will be better understood from a detailed description of exemplary embodiments thereof described in conjunction with the accompanying drawings, wherein
- **Fig. 1**: shows a digital filter according to a first preferred embodiment of the invention;
- **Fig. 2**: shows a digital filter according to a second preferred embodiment of the invention;
- **Fig. 3**: shows an undistorted double sideband AM signal;
- **Fig. 4**: shows a double sideband AM signal which is disturbed by two interferers;
- **Fig. 5**: shows the transfer function of an interferer suppression filter to generate a signal as shown in Fig. 3 from the signal as shown in Fig. 4;
- **Fig. 6**: shows a block diagram of a digital filter according to a third preferred embodiment of the present invention;
- **Fig. 7**: shows signals appearing in the digital filter as shown in Fig. 6; and
- **Fig. 8**: shows a notch filter using a complementing multirate filter according to the prior art.

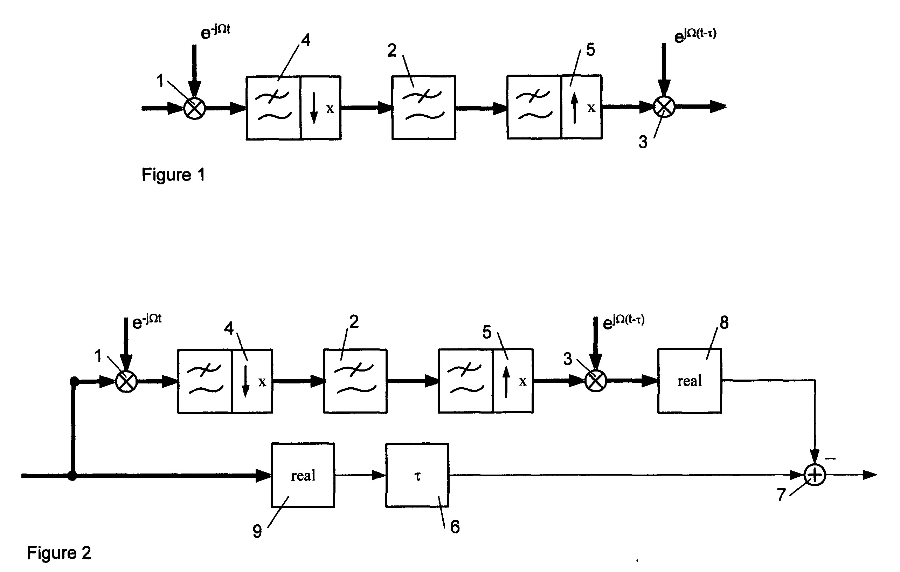

Fig. 1 shows a block diagram of a digital bandpass filter according to a first preferred embodiment of the present invention. A complex valued input signal which should be filtered around the frequency Ω is input to a first complex mixer 1 which shifts the frequency Ω to the baseband, e. g. to the frequency 0, by a multiplication of the input signal with e^{-jΩt}. Thereafter, the frequency shifted input signal is downsampled by a decimator 4 to reduce the calculation power needed within the following filtering stage 2. The decimator 4 decimates the sampling rate of the input signal by a factor x which depends on the required bandwidth and the required transition bands of the designed complex bandpass filter. After the filtering with an arbitrary sharp filter 2 the frequency shifted downsampled and filtered input signal gets upsampled by an interpolator 5 with an interpolation factor x equal to the decimation factor x to achieve a sampling rate similar to that of the input signal. The resulting signal is fed to a second complex mixer 3 to compensate the frequency shift of the first complex mixer 1 by a multiplication e^{jΩt}. To provide the correct phase at the output of the second complex multiplier 3 the group delay τ of the downsampling, the filtering and the upsampling is also considered in that the second complex mixer performs in total a multiplication e^{jΩ(t-τ)}.

Fig. 2 shows a block diagram of a digital bandstop filter according to a second preferred embodiment of the present invention which is realized similar as a complementing multirate filter. Therefore, the input signal is filtered according to the filter shown in Fig. 1 and additionally delayed by a delay element 6 having a delay corresponding to the group delay introduced within the filter path as it is shown in Fig. 1. Further, the output signals of the filter path and of the delay element 6 are added/subtracted by an adder 7 to produce the filtered output signal. Therewith, all advantages of complementary filters as described by N. J. Fliege in the book "Multirate digital signal processing" can also be achieved according to the present invention.

As will be shown in the following example, the present invention is advantageously applicable to the suppression of interferers in double sideband AM broadcasting without information loss.

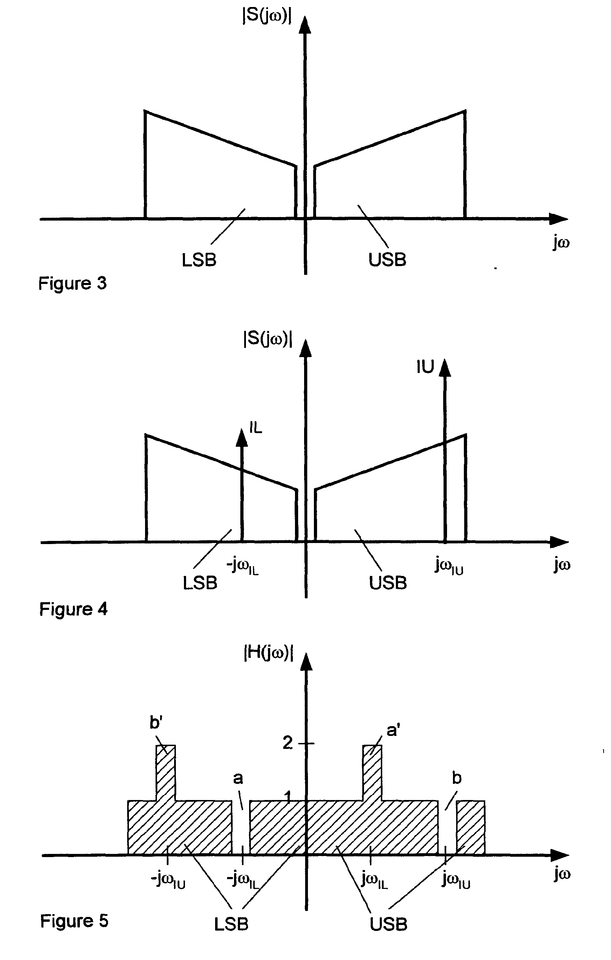

Fig. 3 shows an undisturbed double sideband AM signal which consists of two sidebands containing the same information, namely the lower sideband LSB and the upper sideband USB. The spectrum S(jω) of the lower sideband LSB and the upper sideband USB is symmetrical, i. e. the value of the spectrum of a negative frequency -jω of the lower sideband LSB which covers the negative frequencies is equal to the value of the spectrum of the same positive frequency +jω of the upper sideband USB which covers the positive frequencies.

Interferers which result from single sinus tones caused by other technical devices or by distortion carriers from other transmitters usually appear in one sideband.

Fig. 4 shows a complex baseband signal with one interferer IL in the lower sideband LSB and one interferer IU in the upper sideband USB. Both interferers appear as a peak in the spectrum of the complex baseband signal, since they represent a single sinus tone, respectively. The grade of interference is dependent on the amplitude of the respective peak, i. e. on the absolute value of the spectrum |S(jω)| at the respective frequency jω of the interferer. In the shown example the interferer IL within the lower sideband LSB has a smaller amplitude than the interferer IU in the upper sideband USB.

As the two sidebands in AM broadcasting contain the same information a redundancy is given. Therefore, to suppress such distortions without information loss the distortions are detected and respective subbands comprising said distortions are indicated, which subbands preferably are as narrow as possible, i. e. might comprise more or less only the frequency of the interferer. Thereafter, it is possible to suppress the interferer in the disturbed sideband and use the undisturbed sideband to compensate the information loss within the disturbed sideband.

The general scheme of the detection of interferers is described in the parallel european patent application "Detection of distortions in AM signals" of the applicant and the general scheme of the suppression of interferers is described in the parallel european patent application "Distortion canceller and method to suppress distortions in an AM signal" of the applicant which contents are herewith incorporated by reference into this application.

Fig. 5 shows the transfer function of a filter which is able to suppress the distortions shown in Fig. 4 without any information loss, i. e. generating a signal as shown in Fig. 3. Basically, the transfer function |H(jw)| is designed to have a passband for the lower sideband LSB and the uper sideband USB, i. e. an amplification factor 1 over the whole frequency range of both sidebands. However, since the lower sideband LSB comprises the interferer IL at the frequency -jωIL the transfer function |H(jω)| comprises a signal part a around said frequency -jωIL having an amplification factor 0 to suppress said interferer IL. Further, since the upper sideband USB comprises an interferer IU at the frequency jωIU the transfer function |H(jω)| comprises a signal part b around the frequency jωIU having an amplification factor 0 to suppress said interferer IU. To compensate this removal of information or energy the redundancy of upper and lower sideband is used. Therefore, the transfer function |H(jω)| of the filter according to the present invention comprises a signal part a' corresponding to the signal part a, but arranged around the frequency jωIL having an amplification factor 2 and a signal part b' corresponding to the signal part b, but arranged around the frequency -jωIU having an amplification factor 2.

When now both sidebands are added together there is no loss of information/ energy and additionally a better SNR (signal to noise ratio) is gained, since both sidebands comprise uncorrelated white noise which is subjected to cancellation when adding both sidebands.

Such a transfer function as shown in Fig. 5 can advantageously be realized with a digital filter according to the present invention which is built as complementing multirate filter with a pair of filter paths for every distortion which should be removed from the double sideband AM signal.

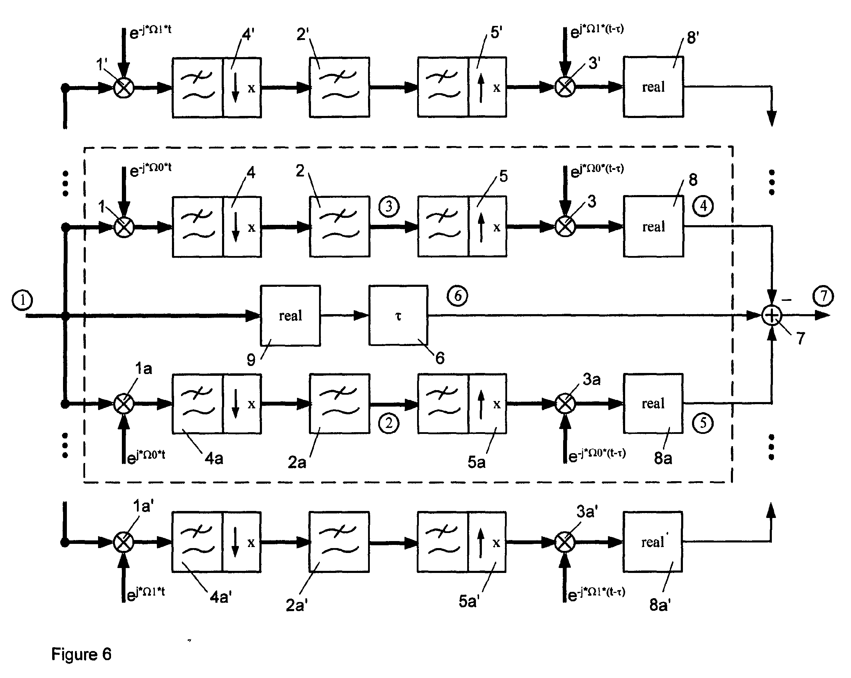

Fig. 6 shows a block diagram of such an interferer filter according to the present invention using multirate filters and Fig. 7 shows signals appearing in Fig. 6.

In particular, the complex valued input signal ① with a detected interferer with frequency Ω0 in the upper sideband is filtered twice so that in one filter path consisting of first complex mixer 1, a decimator 4, a filter 2, an interpolator 5, a second complex mixer 3, and a real part calculation unit 8 the distorted sideband is filtered and in the other filter path comprising a first complex mixer 1a, a decimator 4a, a filter 2a, an interpolator 5a, a second complex mixer 3a and real part calculation unit 8a the corresponding undistorted sideband is filtered.

Therefore, the filtering is basically performed as described in connection with Fig. 1. Within the first filter path by way of the first complex mixer 1 the distorted subband is mixed into the transition band of the following filter 2 which is a lowpass filter with a passband of the frequency shifted distorted subband to obtain the frequency shifted filtered input signal ③ which gets upsampled by the interpolator 5 before the frequency shift is compensated by way of the second complex mixer 3 and the real part is taken by the real part calculation unit 8 to obtain the output signal ⑤ of the first filter path, i.e. the distorted subband. Further, within the second filter path by way of the first complex mixer 1a the corresponding undistorted subband of the input signal is mixed into the transition band of the following filter 2a which also is a lowpass filter with a passband of the frequency shifted distorted subband to obtain a frequency shifted downsampled filtered input signal ② which gets upsampled by the interpolator 5a before the frequency shift is compensated by way of the second complex mixer 3a and the real part is taken by the real part calculation unit 8a to obtain the output signal ④ of the second filter path, i.e. the undistorted subband corresponding to the distorted subband.

Thereafter, the output signals ⑤, ④ of both filter paths are basically processed as described in connection with Fig. 2, but the output signal of the first filter path, i.e. the distorted subband, is subtracted from the delayed real part of the input signal ⑥ which has a delay τ to compensate the group delay of a filter path and the output signal of the second filter path, i.e. the corresponding undistorted subband, is added to the delayed real part of the input signal ⑥ to gain a filtered input signal ⑦ which comprises all information and no interferers.

As indicated in Fig. 6 by reference signs with a '-sign in case of more than one interferer, e.g. for a detected second interferer with frequency Ω1, additional pairs of filter paths are needed to replace distorted subbands within one sideband with the corresponding undistorted subband of the other sideband.

Since for the filtering only the low frequency part is needed the frequency shifted signals can be downsampled before the actual lowpass filter 2, 2a. Therefore, a very sharp filter can be applied without much calculation power and a realization on a digital signal processor is possible.

Additional to the delay of the real part of the input signal ① to compensate the runtime of the lowpass filtering also the cosinus/sinus functions have to be delayed to avoid phase errors, i. e. an additional phase offset Ωτ in the second cosinus/sinus multiplication avoids further delay memory.

## Claims

1. Digital filter for filtering an input signal, **characterized by** at least one filter path comprising
- a first mixer (1) receiving the input signal to shift a center frequency (Ω) of a frequency range to be filtered of the input signal into the low frequency range,
- a filter (2) with a predetermined transfer function in the low frequency range receiving the frequency shifted input signal, and
- a second mixer (3) to compensate the frequency shift of the first mixer and supplying an output signal of a respective filter path.

2. Digital filter according to claim 1, **characterized in that** said at least one filter path further comprises
- a decimator (4) preceding said filter (2) and receiving the output signal of said first mixer (1) and supplying the sampling rate reduced frequency shifted input signal to said filter (2), and
- an interpolator (6) succeeding said filter (2) and receiving the output signal of said filter (2) to compensate the downsampling of said decimator (4).

3. Digital filter according to claim 1 or 2, **characterized by**
- a delay element (6) receiving the input signal and generating a delayed input signal, and
- an adder (7) receiving the output signal of each respective filter path to add/subtract it to/from the delayed input signal,
wherein the delay element (6) compensates the group delay introduced within a filter path.

4. Digital filter according to claim 3, **characterized in that** said input signal is a complex double sideband or amplitude modulated signal and at least one pair of filter paths is arranged so that a respective first path extracts a respective predetermined frequency range of one sideband which is removed from the delayed input signal by subtracting it therefrom and a respective second path extracts a respective corresponding predetermined frequency range of the other sideband which replaces the removed part within the delayed input signal by adding it thereto.

5. Digital filter according to claim 4, **characterized by**
- a first real part calculation unit (8) within each filter path succeeding each second mixer (3), and
- a second real part calculation unit (9) preceding said delay element (6).

6. Digital filter according to anyone of the preceding claims, **characterized in that** said first and second mixers (1, 3) are complex mixers.

7. Digital filter according to anyone of the preceding claims, **characterized in that** said center frequency (Ω) is shifted to zero.

8. Method for digitally filtering an input signal, **characterized by**
- shifting a center frequency of a frequency range to be filtered of the input signal into the low frequency range,
- filtering the frequency shifted input signal with a predetermined transfer function in the low frequency range, and
- compensating the frequency shift.

9. Method according to claim 8, **characterized by**
- downsampling the frequency shifted input signal before said filtering, and
- upsampling the filtered frequency shifted input signal to compensate the downsampling.

10. Method according to claim 8 or 9, **characterized by**
- delaying the input signal, and
- adding/subtracting the filtered input signal to/from the delayed input signal,
wherein the delaying compensates the group delay introduced within the filtering.
